## Europäisches Patentamt

## European Patent Office

## Office européen des brevets

(19)

(11) Veröffentlichungsnummer : **0 120 282**
**B1**

(12) **EUROPÄISCHE PATENTSCHRIFT**

(45) Veröffentlichungstag der Patentschrift :
11.10.89

(51) Int. Cl.⁴ : **G 11 C 11/40**

(21) Anmeldenummer : **84101758.5**

(22) Anmeldetag : **20.02.84**

(54) Leseverstärkerschaltung für einen statischen MOS Speicher.

(30) Priorität : **28.02.83 DE 3307015**

(43) Veröffentlichungstag der Anmeldung :
**03.10.84 Patentblatt 84/40**

(45) Bekanntmachung des Hinweises auf die Patenterteilung : **11.10.89 Patentblatt 89/41**

(84) Benannte Vertragsstaaten :
**AT CH DE FR IT LI**

(56) Entgegenhaltungen :
**EP—A— 0 023 329**
**US—A— 4 150 441**
**SIEMENS FORSCHUNGS- UND ENTWICKLUNGSBE-**
**RICHTE, Band 11, Nr. 4, 1982, Seiten 199-203,**
**Würzburg, DE; K. HORNINGER et al.: "An 8-kbit static**
**RAM with timer and input-output ports"**
**IDEM**
**IEEE JOURNAL OF SOLID-STATE CIRCUITS, Band**
**SC-11, Nr. 5, Oktober 1976, Seiten 602-609, IEEE, New**
**York, US; J.M. SCHLAGETER et al.: "Two 4K static 5-**
**V RAM's"**

(73) Patentinhaber : **Siemens Aktiengesellschaft**
**Wittelsbacherplatz 2**
**D-8000 München 2 (DE)**

(72) Erfinder : **Horninger, Karlheinrich, Dr.**
**Riederinger Strasse 9**
**D-8011 Eglharting (DE)**

**Beschreibung**

Die Erfindung bezieht sich auf einen statischen MOS-Speicher gemäß dem Oberbegriff des Patentanspruchs 1.

Statische MOS Speicher sind bekannt (Siemens Forschungs-und Entwicklungsberichte, Bd. 11, Nr. 4, 1982, S. 199 bis 203, Würzburg DE ; K. Horninger et al.: « An 8-Kbit static RAM with timer and input-output ports »). Die einzelnen statischen Speicherzellen sind dabei jeweils zwischen zwei Bitleitungen angeordnet, die im folgenden Bitleitungspaar genannt werden. Jede Speicherzelle ist über einen ersten Auswahltransistor mit der einen Bitleitung des Bitleitungspaares und über einen zweiten Auswahltransistor mit der anderen Bitleitung des Bitleitungspaares verbunden. Die Auswahltransistoren werden mit Hilfe einer Wortleitung angesteuert. Soll eine Speicherzelle ausgelesen werden, dann wird die Wortleitung angesteuert und über die der Speicherzelle zugeordneten Auswahltransistoren eine der vorher vorgeladenen Bitleitungen umgeladen. Dadurch entsteht eine Potentialdifferenz zwischen beiden der Speicherzelle zugeordneten Bitleitungen. Diese Potentialdifferenz zwischen den Bitleitungen des Bitleitungspaares wird mit Hilfe einer Leseverstärkerschaltung ausgewertet.

Als Leseverstärkerschaltung kann ein Differenzverstärker verwendet werden. Der Differenzverstärker hat den Vorteil, daß er, sobald eine Potentialdifferenz an dem Bitleitungspaar vorhanden ist, diese verstärkt. Ein Nachteil ist die geringe Verstärkung von nur einer Stufe, so daß oft zwei oder gar drei Differenzverstärker hintereinander geschaltet werden. Da diese Differenzverstärker im allgemeinen nicht in die Teilung der Speicherzellen passen, müssen sie hinter den Transfertransistoren des Bitdecoders angeordnet werden. Allerdings übertragen die Transfertransistoren des Bitdecoders das Bitleitungssignal verzögert an den Eingang des Differenzverstärkers. Weiterhin muß mit Hilfe einer Regelschaltung dafür gesorgt werden, daß der Arbeitspunkt des Differenzverstärkers durch die unvermeidlichen Prozeßschwankungen konstant gehalten wird.

Eine weitere bekannte Leseverstärkerschaltung (EP-A-0 023 329) ist das kreuzgekoppelte bistabile Kippglied mit Fußpunkttransistor. Diese ist gegenüber einem Differenzverstärker einfacher aufgebaut. Deshalb ist es auch möglich, die Leseverstärkerschaltung mit der Teilung der Speicherzelle zu entwerfen, so daß die Transfertransistoren des Bitdecoders erst hinter dem verstärkten Signal angeordnet werden können. Damit wird eine raschere Signalübertragung ermöglicht. Das Problem beim Einsatz einer derartigen Leseverstärkerschaltung mit Fußpunkttransistor ist die richtige Wahl des Einschaltzeitpunktes. Bei statischen MOS-Schaltern bewirkt die Laufzeit auf der Wortleitung, daß die Speicherzellen in der Nähe des Wortdecoders rascher eingeschaltet werden als die am Ende der Wortleitung. Die Leseverstärkerschaltungen dürfen daher erst zu einem Zeitpunkt aktiviert werden, an dem die auszuwertende Potentialdifferenz der Bitleitungen eines Bitleitungspaares einen ausreichenden Wert erreicht haben. Dazu wird eine sog. Dummy-Wortleitung verwendet, die in ihren elektrischen Eigenschaften im wesentlichen denjenigen der Wortleitungen entspricht. Die Steuereingänge der Fußpunkttransistoren der Leseverstärkerschaltungen sind mit dieser Dummy-Wortleitung über eine Verstärkerschaltung oder eine Taktschaltung verbunden. Die Fußpunkttransistoren der Leseverstärkerschaltung werden erst dann eingeschaltet, wenn die Potentialdifferenz auf allen Bitleitungspaaren einen für die Bewertung durch Leseverstärkerschaltungen ausreichenden Wert erreicht hat. Maßgebend für den Einschaltzeitpunkt ist somit das Bitleitungspaar, das vom Wortdecoder am weitesten entfernt ist.

Um den Bewertungsvorgang zu beschleunigen, ist es weiterhin bekannt, den Ausgang des an die Dummy-Wortleitung angeschlossenen Verstärkers mit einer Leitung zu verbinden, mit der das Einschaltsignal am Ausgang des Verstärkers durch eine entsprechende Leitungsführung so versetzt den einzelnen Fußpunkttransistoren der Leseverstärkerschaltungen zugeführt wird, daß die Laufzeiten auf den Wortleitungen und damit die verschiedenen Auswahlzeitpunkte der Speicherzellen berücksichtigt werden (K. Horninger et al).

Die der Erfindung zugrundeliegende Aufgabe besteht darin, einen statischen MOS-Speicher der eingangs angegebenen Art anzugeben, bei dem Leseverstärkerschaltungen derart angeordnet sind und derart aufgebaut sind, daß sie dann eingeschaltet werden, wenn die Potentialdifferenz der Bitleitungen der zugeordneten Bitleitungspaare eine von den bistabilen Kippgliedern auswertbare Größe erreicht hat.

Diese Aufgabe wird bei einem statischen MOS-Speicher der eingangs angegebenen Art gemäß dem Kennzeichen des Patentanspruchs 1 gelöst.

Die Schaltschwelle des Schwellwertschaltkreises, also des Schmitt-Triggers wird somit derart eingestellt, daß der Fußpunkttransistor des bistabilen Kippgliedes dann leitend gesteuert wird, wenn die auf den Bitleitungen auftretende Potentialdifferenz gerade den Wert erreicht hat, um das bistabile Kippglied sicher beeinflussen zu können. Die Laufzeitverhältnisse auf der Wortleitung werden dabei mit Hilfe der Dummy-Wortleitung und mit Hilfe der an die Dummy-Wortleitung angeschlossenen Transistoren der Ansteuerschaltung ausgeglichen.

Um die Belastung der Wortleitung durch den einen Auswahltransistor nachbilden zu können, wird an die Dummy-Wortleitung ein in Länge und Breite und in den Spannungsverhältnissen gleich dem einen Auswahltransistor ausgeführter Belastungstransistor angeschlossen. Zur Nachbildung der Belastung der Wortleitung durch den anderen Auswahltransistor ist an die Dummy-Wortleitung ein Sourcefolger angeschlossen, dessen mit der Dummy-Wortleitung verbundener Transistor in Länge und Breite gleich dem anderen Auswahltransistor ausgeführt ist. Der Ausgang des Sourcefolgers ist mit dem Eingang des Schmitt-Triggers verbunden.

Der Steuereingang des Fußpunkttransistors kann mit dem Ausgang eines binären Verknüpfungsgliedes, z. B. eines NOR-Gliedes, verbunden sein, dessen einer Eingang mit dem Ausgang des Schmitt-Triggers und dessen anderer Eingang mit einer Adressenleitung verbunden ist. Mit Hilfe des Verknüpfungsgliedes ist dann nur die Leseverstärkerschaltung auswählbar, deren Information ausgelesen werden soll. Alle anderen Leseverstärkerschaltungen des MOS Speichers werden nicht aktiviert, was zu einer erheblichen Einsparung an Verlustleistung führen kann.

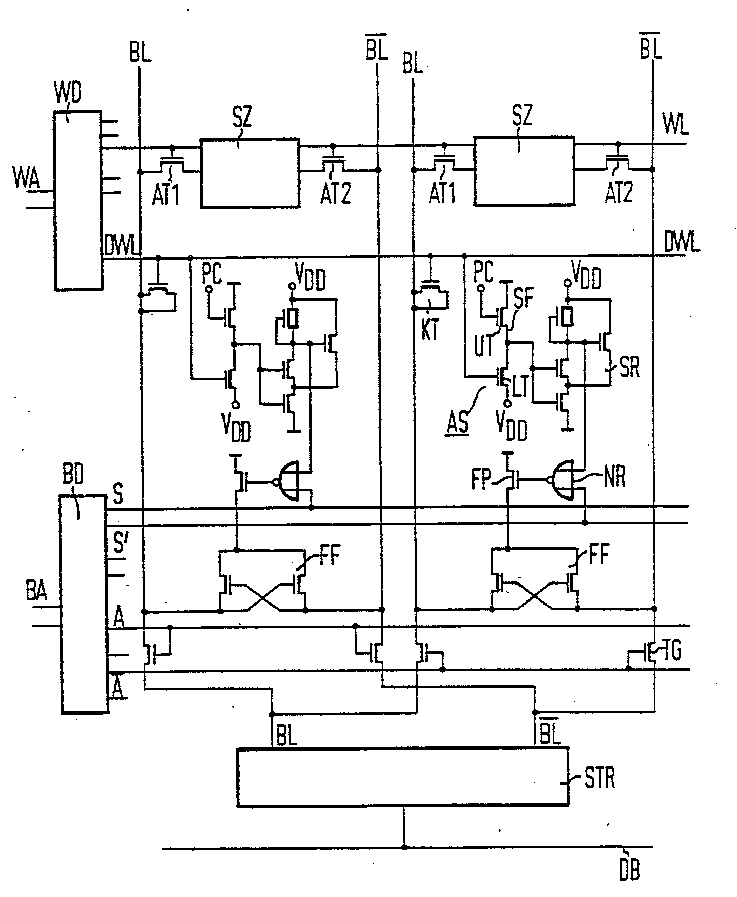

Anhand eines Ausführungsbeispiels, das in der Figur dargestellt ist, wird die Erfindung weiter erläutert. In der Figur ist der Aufbau der Leseverstärkerschaltung ausführlich dargestellt. Die übrigen Teile des statischen MOS Speichers, die bekannt sind und den eingangs angegebenen Literaturstellen entnommen werden können, sind nur prinzipiell dargestellt.

Eine statische Speicherzelle SZ ist jeweils zwischen zwei Bit-Leitungen BL und $\overline{BL}$ angeordnet. Die Verbindung zwischen der Speicherzelle SZ und den Bit-Leitungen BL und $\overline{BL}$ wird mit Hilfe von Auswahltransistoren AT1 und AT2 hergestellt. Die Auswahltransistoren AT1 und AT2 sind mit einer Wortleitung WL verbunden, die zu einem Wortdecoder WD führt. Mit Hilfe des Wortdecoders WD, dem eine Wortadresse WA zugeführt wird, werden gewünschte Wortleitungen WL ausgewählt und die mit den ausgewählten Wortleitungen verbundenen Speicherzellen SZ angesteuert.

Durch die Auswahltransistoren AT1 und AT2 wird die Wortleitung WL sowohl kapazitiv als auch ohmisch belastet. Ein vom Wortdecoder WD auf eine Wortleitung WL abgegebenes Ansteuersignal breitet sich somit auf der Wortleitung WL abhängig von den elektrischen Eigenschaften der Wortleitung aus. Das bedeutet, daß die Speicherzellen SZ, die näher zum Wortdecoder WD liegen früher angesteuert werden als die Speicherzellen SZ, die vom Wortdecoder WD weiter entfernt sind.

Jeder Spalte des MOS Speichers bestehend aus zwischen zwei Bit-Leitungen BL und $\overline{BL}$ angeordneten Speicherzellen SZ ist eine Leseverstärkerschaltung zugeordnet. Die Leseverstärkerschaltung besteht aus einer Ansteuerschaltung AS und aus einem kruezgekoppelten bistabilen Kippglied FF mit Fußpunkttransistor FP. Der Aufbau des kreuzgekoppelten bistabilen Kippgliedes FF und des Fußpunkttransistors FP und deren Funktion ist aus den oben angegebenen Literaturstellen bekannt und wird hier nicht weiter erläutert. Wesentlich ist, daß das kreuzgekoppelte Kippglied FF ebenfalls zwischen den Bit-Leitungen BL und $\overline{BL}$ angeordnet ist und dann schaltet, wenn der Fußpunkttransistor FP leitend gesteuert ist und eine ausreichende Potentialdifferenz zwischen den Bit-Leitungen BL und $\overline{BL}$ besteht.

Der Zeitpunkt, zu dem das Kippglied FF entsprechend der Potentialdifferenz auf den Bit-Leitungen BL und $\overline{BL}$ schalten kann, kann somit mit Hilfe des Fußpunkttransistors FP festgelegt werden. Dies erfolgt mit Hilfe eines Schwellwertschaltkreises, und zwar eines Schmitt-Triggers SR. Der Ausgang des Schmitt-Triggers SR ist mit dem Steuereingang des Fußpunkttransistors FP verbunden. Durch Einstellung der Schaltschwelle des Schmitt-Triggers SR kann festgelegt werden, wann der Fußpunkttransistor FP leitend gesteuert wird. Die Einstellung der Schaltschwelle kann durch die Dimensionierung der Transistoren des Schmitt-Triggers SR erfolgen.

Der Schmitt-Trigger SR wird durch einen Sourcefolger SF angesteuert, dessen Eingang mit einer Dummy-Wortleitung DWL verbunden ist. Mit Hilfe der Dummy-Wortleitung DWL, die als solche bekannt ist, werden die Laufzeiteigenschaften der Wortleitung WL nachgeahmt. Dazu muß die Dummy-Wortleitung DWL entsprechend der Wortleitung WL ausgeführt sein und die Belastung der Wortleitung WL durch die Auswahltransistoren AT1' und AT2 ebenfalls nachgebildet werden. Dazu dient ein Belastungstransistor KT, mit dem der eine Auswahltransistor nachgebildet wird und der Transistor LT des Sourcefolgers SF, mit dem der andere Auswahltransistor nachgebildet wird. Dadurch wird erreicht, daß ein auf die Dummy-Wortleitung DWL gegebenes Signal sich mit entsprechender Geschwindigkeit auf der Dummy-Wortleitung DWL ausbreitet wie ein gleichzeitig auf die Wortleitung WL gegebenes Signal auf der Wortleitung. Um eine den Auswahltransistoren AT1 und AT2 entsprechende Belastung zu erreichen, sind der Belastungstransistor KT und der Transistor LT in Länge und Breite entsprechend der Auswahltransistoren realisiert und diese Transistoren besitzen dieselben Potentialverhältnisse wie die Auswahltransistoren der Speicherzelle SZ.

Der Schmitt-Trigger SR kann direkt mit dem Steuereingang des Fußpunkttransistors FP verbunden sein. Es ist jedoch auch möglich, vor den Fußpunkttransistor FP ein binäres Verknüpfungsglied, z. B. ein NOR-Glied NR, zu schalten und mit Hilfe des Verknüpfungsgliedes den Ausgang des Schmitt-Triggers SR und eine Adressenleitung S bzw.S' zusammenzufassen. Dann ist es möglich, mit Hilfe der Adressenleitungen S bzw. S', die zu einem Bit-Decoder BD führen, einen oder mehrere Leseverstärkerschaltungen gezielt auszuwählen, die übrigen jedoch nicht zu aktivieren.

Hinter den Leseverstärkerschaltungen AS, FF sind in den Bit-Leitungen BL und $\overline{BL}$ Transfertransistoren TG eingeschaltet, deren Steuereingänge mit zu dem Bit-Decoder BD führenden Adressenleitungen A verbunden sind. Der Bit-Decoder BD wählt auf bekannte Weise aus einer Bit-Leitungsadresse BA die Adressenleitung A aus, die der ausgewählten Spalte von Speicherzellen SZ zugeordnet ist. Auf diese Adressenleitung A bzw. A erscheint dann ein die zugeordneten Transfertransistoren TG leitend steuerndes Signal. Die Bit-Leitungen BL bzw. $\overline{BL}$ werden zusammengefaßt ebenfalls einer Schreibschaltung und Treiberschaltung STR, die auf bekannte Weise aufgebaut sein kann, zugeführt, die zudem mit dem Datenbus DB verbunden ist. Über die Schreib- bzw. Bustreiberschaltung STR werden die ausgelesenen Informationen auf den Datenbus gegeben.

Soll aus einer Speicherzelle SZ eine Information ausgelesen werden, dann werden zunächst die Bit-Leitungen BL und $\overline{BL}$ auf eine bestimmte Spannung vorgeladen, z. B. auf ca. 4 Volt. Anschließend wird entsprechend der am Wortdecoder WD anliegenden Wortleitungsadresse WDA vom Wortdecoder WD eine Wortleitung WL ausgewählt und ein Ansteuersignal von z. B. 5 Volt auf diese Wortleitung WL gelegt. Dadurch wird an die Steuereingänge der Auswahltransistoren AT1 und AT2 ein Potential von ca. 5 Volt angelegt. Entsprechend dem Zustand der Speicherzelle SZ wird eine der Bit-Leitungen BL bzw. $\overline{BL}$ über einen der Auswahltransistoren AT entladen. Gleichzeitig mit dem Ansteuersignal auf der Wortleitung WL wird ein Signal auf die Dummy-Wortleitung DWL gegeben. Damit wird die der Speicherzelle SZ zugeordnete Ansteuerschaltung AS und zwar der Sourcefolger SF zum gleichen Zeitpunkt angesteuert, zu dem die Auswahltransistoren AT1 bzw. AT2 durch das Ansteuersignal auf der Wortleitung WL angesteuert werden. Entsprechend der Schaltschwelle des Schmitt-Triggers SR wird dieser am Ausgang ein Signal abgeben, wenn z. B. die Potentialdifferenz zwischen den Bit-Leitungen BL und $\overline{BL}$ ca. 0,5 Volt beträgt. Die Schaltschwelle des Schmitt-Triggers SR kann durch Dimensionierung seiner Transistoren entsprechend eingestellt werden. Dann wird der Fußpunkttransistor FP leitend gesteuert und das bistabile Kippglied FF wird in die durch das Potential auf den Bit-Leitungen BL und $\overline{BL}$ festgelegte Lage kippen. Dabei beschleunigt das Kippglied FF die Umladung einer der Bit-Leitungen z. B. auf ca. 0 Volt. Der Bit-Decoder BD steuert entsprechend der Bit-Leitungsadresse BDA z. B. die Adressenleitung A an und öffnet die zugeordneten Transfertransistoren. Die aus der Speicherzelle SZ ausgelesene und durch die Leseverstärkerschaltung verstärkte Information wird dann über die Bustreiberschaltung STR auf den Datenbus DB gegeben.

In der Figur ist VDD ein Betriebspotential, PC ein einschaltbares Betriebspotential, durch das der Transistor UT des Sourcefolgers SF leitend gesteuert wird.

**Patentansprüche**

1. Statischer MOS-Speicher bestehend aus
Wortleitungen (WL), Bitleitungen (BL, $\overline{BL}$) und zwischen jeweils zwei ein Paar bildenden Bitleitungen (BL, $\overline{BL}$) angeordneten Speicherzellen (SZ), die über von einer Wortleitung angesteuerte Auswahltransistoren (AT1, AT2) mit den Bitleitungen des Bitleitungspaares verbunden sind,
einer Dummy-Wortleitung (DWL), die im elektrischen Verhalten den Wortleitungen (WL) nachgebildet ist und die entsprechend der Belastung der Wortleitungen durch die Auswahltransistoren (AT) durch Belastungselemente belastet ist,
Leseverstärkerschaltungen, von denen jeweils eine zwischen den Bitleitungen eines Bitleitungspaares angeordnet ist und die ein einen einschaltbaren Fußpunkttransistor (FP) enthaltendes kreuzgekoppeltes bistabiles Kippglied (FF) aufweisen, gekennzeichnet durch eine zwischen den Bitleitungen eines Bitleitungspaares angeordnete Ansteuerschaltung (AS) pro Leseverstärkerschaltung zur Ansteuerung des Fußpunkttransistors (FP) des bistabilen Kippgliedes (FF) aus
einem Sourcefolger (SF), dessen Eingang mit der Dummy-Wortleitung (DWL) im Bereich des zugeordneten Bitleitungspaares verbunden ist und der die Dummy-Wortleitung entsprechend der Belastung der Wortleitung durch einen Auswahltransistor belastet,
aus einem an den Sourcefolger (SF) angeschlossenen Schmitt-Trigger (SR), der vom Sourcefolger angesteuert wird, dessen Ausgang mit dem Fußpunkttransistor (FP) des zugeordneten bistabilen Kippgliedes verbunden ist und dessen Schwelle durch die Dimensionierung seiner Transistoren derart eingestellt ist, daß der Fußpunkttransistor erst leitend gesteuert ist, wenn die Potentialdifferenz zwischen den zugeordneten Bitleitungen des Bitleitungspaares einen Wert erreicht hat, durch den das bistabile Kippglied beeinflußbar ist.

2. MOS Speicher nach Anspruch 1 oder 2, dadurch gekennzeichnet, daß zur Nachbildung der durch den einen Auswahltransistor (AT1) auf der Wortleitung (WL) verursachten Belastung an die Dummy-Wortleitung (DWL) ein in Länge und Breite gleich dem Auswahltransistor ausgeführter Belastungstransistor (KT) angeschlossen ist.

3. MOS Speicher nach einem der vorhergehenden Ansprüche, dadurch gekennzeichnet, daß zur Nachbildung der durch den anderen Auswahltransistor (AT2) auf der Wortleitung (WL) verursachten Belastung an die Dummy-Wortleitung (DWL) der mit der Dummy-Wortleitung verbundene Transistor (LT) des Sourcefolgers (SF) derart ausgeführt ist, daß er in Länge und Breite und in den Spannungsverhältnissen dem anderen Auswahltransistor (AT2) entspricht.

4. MOS Speicher nach einem der vorhergehenden Ansprüche, dadurch gekennzeichnet, daß der Steuereingang des Fußpunkttransistors (FP) mit dem Ausgang eines binären Verknüpfungsgliedes (MR) verbunden ist, dessen einer Eingang mit dem Ausgang des Schwellwertschaltkreises (SR) und dessen anderer Eingang mit einer Adressenleitung (S, S') verbunden ist.

**Claims**

1. Static MOS memory consisting of
word lines (WL), Bit lines (BL, $\overline{BL}$) and arranged between in each case two bit lines (BL, $\overline{BL}$) forming a pair memory elements (SZ) which are connected to the bit lines of the pair of bit lines via selection transistors (AT1, AT2) activated by a word line,

a dummy word line (DWL), which is simulates the electrical behaviour of the word lines (WL) and which is loaded by loading elements in accordance with the loading on the word lines by the selection transistors (AT),

read amplifier circuits, of which in each case one is arranged between the bit lines of a pair of bit lines and which have a cross-coupled bistable multivibrator (FF) containing a base transistor (FP) which can be switched on, characterized by one activation circuit (AS) arranged between the bit lines of a pair of bit lines per read amplifier circuit for activating the base transistor (FP) of the bistable multivibrator (FF), consisting of

a source follower (SF), the input of which is connected to the dummy word line (DWL) in the region of the associated pair of bit lines, and which loads the dummy word line in accordance with the load on the word line by means of a selection transistor,

of a Schmitt trigger (SR) connected to the source follower (SF) and activated by the source follower, the output of which is connected to the base transistor (FP) of the associated bistable multivibrator, and the threshord of which is set by the dimensioning of its transistors in such a way that the base transistor is only switched to be conductive when the potential difference between the associated bit lines of the pair of bit lines has reached a value with which the bistable multivibrator can be influenced.

2. MOS memory according to claim 1 or 2, characterized in that, for simulating the load on the word line (WL) caused by the one selection transistor (AT1), a load transistor (KT) which is designed the same as the selection transistor in terms of length and width is connected to the dummy word line (DWL).

3. MOS memory according to one of the preceding claims, characterized in that, for simulating the load on the word line (WL) caused by the other selection transistor (AT2) on the dummy word line (DWL), the transistor (LT) of the source follower (SF) connected to the dummy word line is designed in such a manner that it corresponds in terms of length and width and in terms of the voltage ratios to the other selection transistor (AT2).

4. MOS memory according to one of the preceding claims, characterized in that the control input of the base transistor (FP) is connected to the output of a binary gating element (MR), one input of which is connected to the output of the threshold circuit (SR) and the other output of which is connected to an address line (S, S').

## Revendications

1. Mémoire MOS statique constituée par

des lignes de transmission de mots (WL), des lignes de transmission de bits (BL, $\overline{BL}$) et des cellules de mémoire (SZ), qui sont disposées entre deux lignes respectives de transmission de bits (BL, $\overline{BL}$) formant un couple et sont reliées, par l'intermédiaire de transistors de sélection (AT1, AT2) commandés par une ligne de transmission de mots, aux lignes de transmission de bits du couple de lignes de transmission de bits,

une ligne fictive de transmission de mots (DWL), qui est simulée lors du comportement électrique des lignes de transmission de mots (WL) et est chargée par des éléments de charge conformément à la charge appliquée aux lignes de transmission de mots par l'intermédiaire des transistors de sélection (AT),

des circuits amplificateurs de lecture, dont l'un est disposé respectivement entre les lignes de transmission de bits d'un couple de lignes de transmission de bits qui comportent un circuit à bascule bistable (FF) à couplage croisé, contenant un transistor de contrôle de la mise à la masse (FP) pouvant être placé à l'état conducteur, caractérisé par un circuit de commande (AS) disposé entre les lignes de transmission de bits d'un couple de lignes de transmission de bits, pour chaque circuit amplificateur de lecture, pour la commande du transistor de contrôle de la mise à la masse (FP), du circuit à bascule bistable (FF), et constitué par

un montage en source suiveuse (SF), dont l'entrée est reliée à la ligne fictive de transmission de mots (DWL), au voisinage du couple associé de lignes de transmission de bits et qui charge la ligne fictive de transmission de mots conformément à la charge appliquée à la ligne de transmission de mots par un transistor de sélection,

un déclencheur de Schmitt (SR), qui est raccordé au montage en source suiveuse (SF) et est commandé par ce dernier, et dont la sortie est reliée au transistor de contrôle de mise à la masse (FP) du circuit à bascule bistable associé et dont le seuil est réglé au moyen du dimensionnement de ses transistors de telle sorte que ce transistor de contrôle n'est placé à l'état conducteur que lorsque la différence de potentiel entre les lignes associées de transmission de bits du couple de lignes de transmission de bits a atteint une valeur, à l'aide de laquelle l'étage à bascule bistable peut être influencé.

2. Mémoire MOS selon la revendication 1 ou 2, caractérisée par le fait qu'un transistor de charge (KT), dont la longueur et la largeur sont égales à celles du transistor de sélection, est raccordé de manière à simuler la charge provoquée par un transistor de sélection (AT1) dans la ligne de transmission de mots (WL) et appliquée à la ligne fictive de transmission de mots (DWL).

3. Mémoire MOS suivant l'une des revendications précédentes, caractérisée par le fait que, pour la simulation de la charge provoquée par l'autre transistor de sélection (AT2) dans la ligne de transmission de mots (WL) et appliquée à la ligne fictive de transmission de mots (DWL), le transistor (LT), relié à la ligne fictive de transmission de mots, du montage en source suiveuse (SF) est réalisé de manière à correspondre à l'autre transistor de sélection (AT2) du point de vue de sa longueur et de sa largeur et des conditions de tension.

4. Mémoire MOS suivant l'une des revendications précédentes, caractérisée par le fait que l'entrée de commande du transistor de contrôle (FP) est raccordée à la sortie d'un circuit combinatoire binaire (MR), dont une entrée est reliée à la sortie du circuit à valeur de seuil (SR) et dont l'autre entrée est raccordée à une ligne de transmission d'adresses (S, S').